# EUROPEAN PATENT SPECIFICATION

(11) **EP 2 907 188 B1**
(45) Date of publication and mention of the grant of the patent: **07.12.2016**
(21) Application number: 13789613.0
(22) Date of filing: 11.10.2013
(51) Int. Cl.: H01M 8/24, H01M 8/04, H01M 8/00

(54) **CELL VOLTAGE MONITORING CONNECTOR SYSTEM FOR A FUEL CELL STACK**
STECKERSYSTEM ZUR SPANNUNGSÜBERWACHUNG VON BRENNSTOFFZELLEN
SYSTÈME DE CONNECTEUR POUR LE CONTRÔLE DE TENSION DE PILES À COMBUSTIBLE

(30) Priority: 15.10.2012 GB 201218429
(43) Date of publication of application: 19.08.2015
(73) Proprietor: Intelligent Energy Limited, Loughborough LE11 3GB (GB)
(72) Inventor: HORLOCK, Mark, Phillip, Loughborough LE11 3GB (GB); KUPCHO, Kevin, Loughborough LE11 3GB (GB)
(74) Representative: Potter Clarkson LLP
(86) International application number: PCT/GB2013/052658
(87) International publication number: WO 2014/060727

(56) References cited:
- EP-A1- 2 154 745
- JP-A- 2009 266 410
- US-A1- 2004 028 969
- US-A1- 2004 227 518
- US-A1- 2007 108 960

## Description

The present invention relates to electrical connector systems used in fuel cell stacks to make electrical connections to a plurality of individual cells within a fuel cell stack.

Conventional electrochemical fuel cells convert fuel and oxidant into electrical and thermal energy and a reaction product. A typical fuel cell comprises a membrane-electrode assembly (MEA) sandwiched between an anode flow field plate and a cathode flow field plate. Gas diffusion layers may be disposed between each flow field plate and the MEA. Gaskets may be used to separate various layers and to provide requisite seals. The flow field plates typically include one or more channels extending over the surface of the plate adjacent to the MEA for delivery of fluid fuel or oxidant to the active surface of the MEA.

In a conventional fuel cell stack, a plurality of cells are stacked together, so that the anode flow field plate of one cell is adjacent to the cathode flow field plate of the next cell in the stack, and so on. In some arrangements, bipolar flow plates are used so that a single flow field plate has fluid flow channels in both sides of the plate. One side of the bipolar plate serves as an anode flow plate for a first cell and the other side of the flow plate serves as a cathode flow plate for the adjacent cell. Power can be extracted from the stack by electrical connections made to the first and last flow plate in the stack. A typical stack may comprise only a few, many tens or even hundreds, of cells. The present invention is relevant to all of these various fuel cell stack constructions.

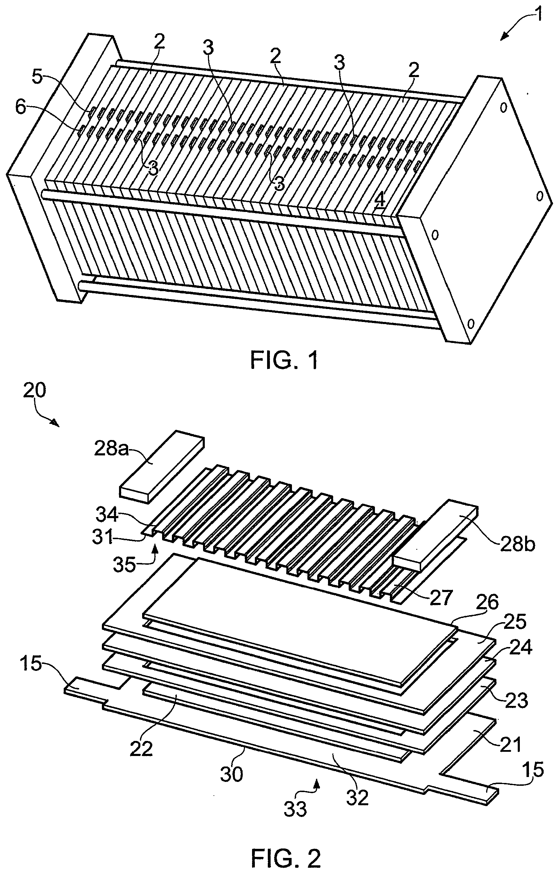

In many fuel cell stacks, it is important to be able monitor the voltage of individual cells in the stack. Thus, it is necessary to provide electrical connection to many (and often to all) of the flow plates in the stack. Conventionally, this has been achieved by providing electrical connector tabs to at least some of the flow plates in the stack. These cell voltage monitoring tabs extend from edges of the flow plates, laterally outward from the stack thereby forming an array of tabs extending outwardly from a face of the stack, so that individual electrical connectors may be coupled to each tab for voltage signal take-off from the flow plates. One arrangement of cell voltage monitoring tabs extending from each flow plate is shown in figure 1.

The fuel cell stack 1 in figure 1 has a plurality of physically parallel cells 2 each of which has an anode flow plate with a respective tab 3 extending outwards from a face 4 of the fuel cell stack. To decrease the packing density of the tabs (i.e. to increase the separation of adjacent tabs) or to provide additional connection points to the same or different plates in the stack, the tabs 3 may be formed in two (or more) rows 5, 6.

These male tabs 3 can typically be used with standard female electrical connectors, such as blade receptacles well known in the art. Other techniques include soldering wires to the exposed faces of the tabs. Individually coupling an electrical connector to each tab can be a time consuming process and thus increases manufacturing costs and can also be error prone.

The desire for increased miniaturisation of fuel cells, and thus increased power density, has resulted in the flow plates of fuel cell stacks becoming much thinner. The gauge of materials now desirable for manufacturing flow plates is much less capable, and in some cases incapable, of providing cell voltage monitoring tabs 3, extending outwardly from the face 4 of the stack 1, that are sufficiently robust to facilitate solder connections or friction-fit sliding connectors such as blade receptacles or other clip-on or fasten-on connectors.

A further disadvantage with providing flow plates with laterally extending tabs 3 is that the protruding tabs require an extended footprint of material from which to cut out flow plates, thereby increasing material wastage during the manufacturing process.

US 2007/0108960 A1 discloses a fuel cell voltage measurement device including a mean beam provided at two sides with a transverse slot each for slidably receiving a plurality of sides therein, and a plurality of retractable probe assemblies separately mounted on the slides to move along with the slides.

US 2004/0227518 A1 discloses an invention providing for measuring the voltage across an associated pair of flow field plates of each electrochemical cell in a plurality of electrochemical cells connected in series to form a stack.

It is an object of the present invention to provide an improved solution for forming cell voltage monitoring tabs in fuel cell stacks. It is a further object of the present invention to overcome or mitigate some or all of the above problems.

The present invention provides a fuel cell stack assembly comprising:
a plurality of fuel cells disposed in a stacked configuration, each cell having a membrane-electrode assembly (MEA) sandwiched between an anode flow field plate and a cathode flow field plate,
the flow field plates each extending to a lateral face of the fuel cell stack and each having an exposed portion generally coplanar with the lateral face of the fuel cell stack surface;
a connector assembly having an array of contacts each configured to bias against, and form electrical contact with, a respective one of selected flow field plates at a contact zone thereof, in which each contact is biased against its respective flow plate in a direction in the plane of the respective flow field plate; and
a gasket layer disposed on each side of each flow field plate, the gasket layers supporting the faces of each flow field plate, at least one gasket layer adjacent each selected flow field plate including a rebate at its peripheral edge to expose a portion of the surface of the selected flow field plate inward of the lateral face of the fuel cell stack at the contact zone.

The exposed portion may be an exposed edge of the respective flow field plate and each contact may be biased against the exposed edge of its respective flow plate. The fuel cell stack assembly includes a gasket layer disposed on each side of each flow field plate. The gasket layers may support the faces of each flow field plate adjacent to the exposed edges that are in biased contact with a respective contact. The gasket layers support the faces of each flow field plate, at least one gasket layer adjacent each selected flow field plate including a rebate at its peripheral edge to expose a portion of the surface of the selected flow field plate inward of the lateral face of the fuel cell stack at the contact zone. The fuel cell stack assembly may include a recess in the lateral face of the fuel cell stack at the contact zones. The anode flow plate of one cell may comprise the cathode flow plate of an adjacent cell, in a bipolar plate configuration. The connector assembly may comprise a plurality of spring fingers extending in a plane parallel or near parallel to the lateral face of the stack, each spring finger being biased towards the plane of the lateral face of the stack to engage with the exposed portion of the respective one of the flow field plates. The connector assembly may comprise a resilient substrate defining a plurality of fingers extending from a supporting spine in a comb-like configuration, the electrical contacts being disposed on the spring fingers. The connector assembly may comprise a plurality of spring loaded pins each biased and extending towards the plane of the lateral face of the stack to engage with the exposed portion of the respective one of the flow field plates. The connector assembly may comprise a substrate on which is mounted a plurality of flexing contacts extending away from the substrate to a knuckle contact portion. The connector assembly may be integrated onto a side plate or housing of the stack. The recess may comprise a corner rebate in the stack at the contact zones. The exposed portion may be a buckled or folded peripheral portion of the respective flow field plate and each contact may be biased against the buckled or folded portion of its respective flow plate to thereby form the electrical contact with the respective flow field plate. The fuel cell stack assembly may include a second connector assembly having an array of contacts each configured to bias against, and form electrical contact with, a respective one of selected flow plates at a contact zone thereof, in which each contact is biased against its respective flow plate in a direction in the plane of the respective flow plate, the second connector assembly being disposed on an opposite face of the fuel cell stack to the first connector assembly, to provide contact biasing in the opposite direction to the contacts of the first connector assembly.

Embodiments of the invention will now be described by way of example and with reference to the accompanying drawings in which:
Figure 1 is a perspective view of a fuel cell stack with a side face having an array of cell voltage monitoring electrical connection tabs extending out of the side face from each cell;
Figure 2 is a perspective exploded view of components of a fuel cell showing schematically the disposition of flow plates, gaskets and membrane electrode assembly;
Figure 3 is a schematic perspective view of a connector assembly deploying spring fingers and inset diagrams showing exemplary spring fingers in cross-sectional profile;
Figure 4 is a schematic cross-sectional view of a connector assembly deploying spring-loaded pins;
Figure 5 is a schematic cross-sectional view of a connector assembly deploying hooked spring fingers, with inset diagrams showing exemplary spring fingers in cross-sectional profile;
Figures 6a and 6b are schematic cross-sectional views of a part of the fuel cell stack showing electrical contact of a biased contact to an anode flow plate of the stack;
Figure 7 is a perspective view of a corner portion of a fuel cell stack with a connector assembly partially detached to illustrate components thereof;
Figure 8 is a schematic plan view of a portion of a fuel cell illustrating a recessed flow plate connector zone and hooked spring finger connector; and
Figure 9 is a perspective view of a portion of a fuel cell stack showing recessed flow plate connector zones.

Figure 2 shows a schematic diagram of components of a fuel cell for an open cathode type fuel cell stack in exploded form for clarity. Each cell 20 includes an anode flow plate 21, an anode gasket 23, a membrane-electrode assembly (MEA) 24, a cathode gasket 25 and a cathode flow plate 27. The anode gasket 23 provides a fluid tight seal between the anode flow plate 21 and the MEA 24 and defines a frame around an anode diffuser 22. Similarly, the cathode gasket 25 provides a fluid tight seal between the cathode flow plate 27 and the MEA 24 and defines a frame around a cathode diffuser 26. In the particular arrangement of figure 2, the cathode flow plate is provided as a corrugated cathode separator plate 27 and a pair of manifold gaskets 28a, 28b are provided at each end thereof. The gaskets may comprise an elastomeric or other compressible and flexible material suitable for providing a fluid tight seal against the cathode separator plate 27 and against an adjacent cathode gasket 25 and against an adjacent anode plate from the next cell (not shown in figure 2). The gasket 23 should be sufficiently compressible so as to absorb any minor variations in thickness of the adjacent components and to absorb any distortion in the fuel cell stack assembly while maintaining an adequate fluid seal against adjacent components.

In other arrangements, the fuel cell could be a closed cathode system, for example in which the cathode flow plate could be a flat plate with channels extending in a surface thereof. In other arrangements, the cathode flow plate of one cell could be combined with the anode flow plate of an adjacent cell as a bipolar plate.

In the design of fuel cell shown in figure 2, the anode flow plate 21 includes exemplary electrical connection tabs 15 (e.g. cell voltage monitoring tabs) each extending laterally outward from an edge of the flow plate 21. These tabs 15 would have a rigidity and spacing determined by the structure and position of the anode flow plate. The potential disadvantages of such tabs have been discussed above.

In the present invention, it has been recognised that the tabs 15 can be replaced with an alternative connection system in which electrical connection to each flow plate 21 or 27 can be made directly with an edge of the flow plate rather than to the faces of a tab extending laterally outward from a face 4 of the stack, provided that the flow plate edges are sufficiently well supported. The expression "edge" of a flow plate is intended to define an outwardly facing edge 30 or 31 respectively on the anode flow plate or the cathode flow plate. The edge 30 or 31 extends transversely, and preferably orthogonally, to and between the upper and lower faces 32, 33 or 34, 35 that define the plane of the sheet forming the flow plate. The edge 30, 31, is therefore generally co-planar with the face 4 of the stack 1.

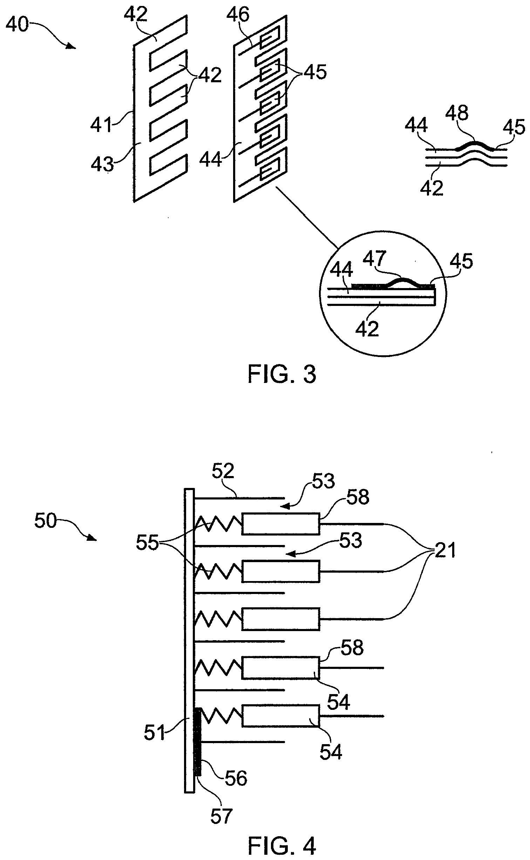

Figure 3 shows a schematic perspective exploded view of a connector assembly 40 having a flexible plate 41 defining a plurality of spring fingers 42 each extending from a supporting spine 43 in a comb-like arrangement. The flexible plate is preferably formed of a stiff plastics material, steel or other suitable material which will impart sufficient resilience to the fingers 42 to enable them to provide a biasing force when bent slightly out of the plane of the flexible plate. The flexible plate 41 supports a semi-rigid printed circuit board 44 which may have a shape generally correspondent to that of the flexible plate. The semi-rigid printed circuit board is mounted onto the face of the flexible plate 41 using a suitable bonding material or any other fixing mechanism such as clipping at discrete locations. The printed circuit board 44 includes a plurality of electrical contact areas 45 each of which includes an electrically conductive track 46 extending therefrom to a suitable termination point 46 where external wiring can be connected. The fingers 42 and/or 45 may be planar when unbiased or may have a curved contact bump 47 protruding therefrom or other curved profile 48, as shown in the two inset diagrams, to enhance electrical connection. In a general aspect, the connector assembly 40 provides a plurality of spring fingers 42 extending in a plane parallel or near parallel to the lateral face 4 of the stack and each spring finger is biased towards the plane of the lateral face of the stack to engage with an exposed portion of a flow field plate 21.

In an alternative arrangement, the flexible plate 41 could be fabricated from a suitable electrically insulating material onto which electrical contact areas 45 and electrically conductive tracks 46 can be disposed directly.

In use, the electrical contact areas 45 are biased against a face 4 of a fuel cell stack 1 to form electrical connections to flow plates as will be described shortly.

Figure 4 shows an alternative arrangement of a connector assembly 50. In this arrangement, a rigid or semi-rigid plate 51 has disposed thereon a housing 52 defining a plurality of chambers 53 each of which houses a spring-loaded pin 54, biased to the right as drawn by a spring 55. The rigid or semi-rigid plate 51 may comprise a printed circuit board on which are disposed a plurality of electrically conductive tracks 56 extending from each spring 55 to a suitable termination point 57 where electrical wiring can be connected. Each spring-loaded pin 54 defines a pressure contact face 58.

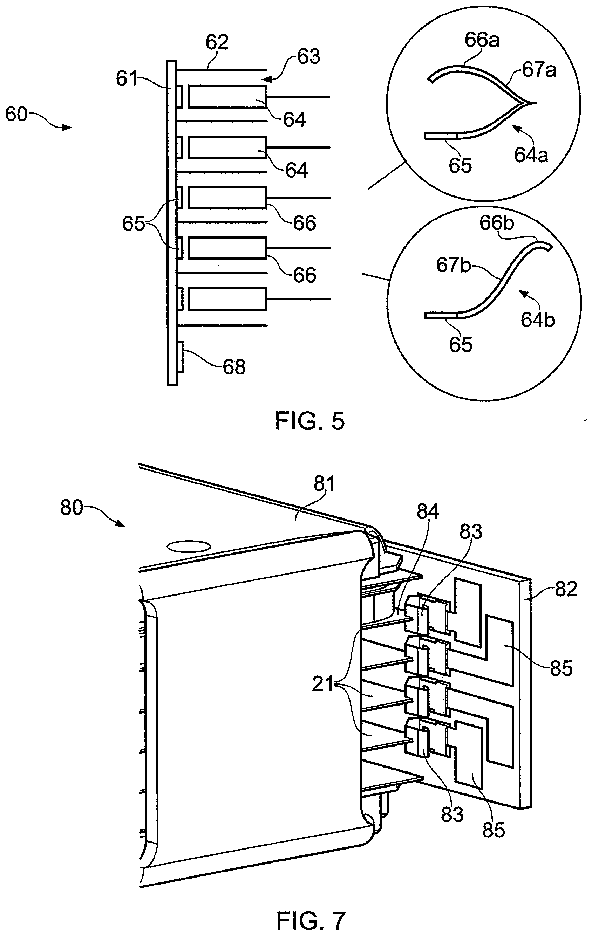

In use, the pressure contact face 58 of each pin 54 is biased against a face 4 of a fuel cell stack 1 to form an electrical connection to an edge of a flow plate 21 as shown schematically in figure 5 and as will be described in more detail shortly.

Thus, in a general aspect, the connector assembly 50 provides a plurality of spring loaded pins each biased and extending towards the plane of the lateral face 4 of the stack to engage with an exposed portion of a flow field plate.

Figure 5 shows an alternative arrangement of a connector assembly 60. In this arrangement, a rigid or semi-rigid plate 61 has disposed thereon a housing 62 defining a plurality of chambers 63 each of which houses a flexing contact 64 which extends from a foot plate 65 where it is coupled to the plate 61 to a knuckle 66a or 66b where electrical contact can be made (as seen in the two inset diagrams showing two possible cross-section profiles of the flexing contacts 64). The flexing contact 64 is preferably formed of a springy metal which provides a spring bias to the knuckle 66. The flexing contact may be formed with a crooked or v-shaped arm 67a or a single oblique section arm 67b, according to preference and/or space constraints. The rigid or semi-rigid plate 61 may comprise a printed circuit board on which are disposed a plurality of electrically conductive tracks (not shown) extending from each flexing contact 64 to a suitable termination point 68 where electrical wiring can be connected. Each knuckle 66 defines a pressure contact face.

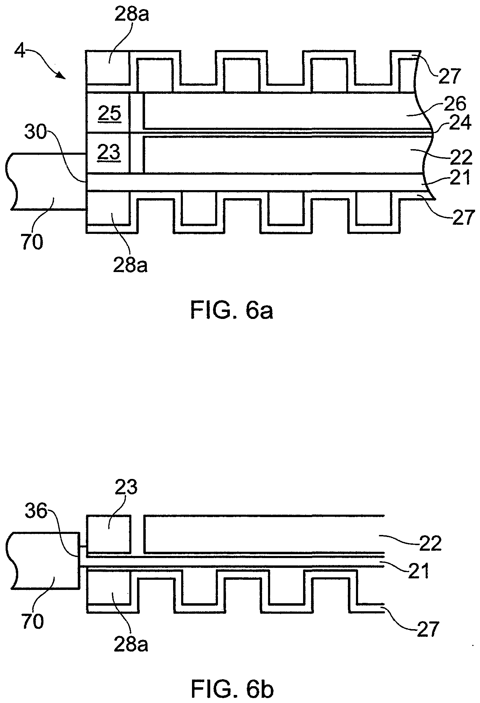

In use, the pressure contact face of each knuckle is biased against a face 4 of a fuel cell stack 1 to form an electrical connection to an edge of a flow plate 21 as shown schematically in figure 6 and as will be described in more detail shortly.

Figure 6a shows a schematic cross-section through a portion of the fuel cell stack indicating the general principles of the electrical contact between a biased contact of the connector assembly and the anode flow plate of a cell 2 in the fuel cell stack 1. Common reference numerals have been used with figure 2 to identify relevant components. Starting from the bottom of the diagram, a cathode flow plate 27 from a lower cell (the rest of which is not shown) is coupled to the anode flow plate 21 of the subject cell. A gasket 28a forms a peripheral edge of the cathode flow plate 27 and seals the edge to the adjacent anode flow plate. An anode diffuser 22 separates the anode flow plate 21 from the MEA 24 and is bounded by an anode gasket 23. A cathode diffuser 26 separates the MEA 24 from the cathode flow plate 27 and is bounded by cathode gasket 25. Cathode flow plate 27 is coupled to the anode flow plate of the next cell (not shown) and a further gasket 28a seals the edges of these adjacent anode and cathode flow plates.

The biased contact 70 abuts the edge 30 of the anode flow plate 21 to make electrical contact thereto. For clarity, the anode flow plate 21 is shown with greatly enlarged thickness in the schematic diagram of figure 6 and is physically supported by the adjacent gaskets 28a and 23, which are under compression. The exposed edge 30 of the anode plate 21 is generally co-planar with the face 4 of the fuel cell stack, between the gasket edge surfaces, and is preferably very slightly proud of the face 4.

The biased contact 70 has been exemplified herein by: the electrical contact areas 45 of the flex plate 41 (figure 4); the pressure contact faces 58 of the spring-loaded pins 54; and the knuckles 66a, 66b of the flexing contacts 64.

Figure 6b shows a schematic cross-section through a portion of the fuel cell stack indicating a slightly modified arrangement of electrical contact between a biased contact of the connector assembly and the anode flow plate of a cell 2 in the fuel cell stack 1, still within the general principles described herein. The component parts are the same as in figure 6a, although the diagram is restricted to the anode flow plate 21 and its relationship with the anode gasket 23, manifold gasket 28a and biased contact 70. In this example, the anode flow plate 21 may be a very thin plate susceptible to buckling and/or distortion under the force of biased contact 70 where a peripheral portion of the anode flow plate emerges slightly from the gaskets 23, 28a. In this instance, a small peripheral portion 36 of the face 32 or 33 of the flow plate is forced into electrical contact with the biased contact 70 to make electrical contact thereto.

In figure 6b it will be seen that the periphery of the anode plate 21 is folded or buckled such that it is generally co-planar with the face 4 of the fuel cell stack, i.e. folded over one or both of the adjacent gasket edge surfaces. The anode plate 21 is manufactured very slightly larger than the gasket area so that it lies sufficiently proud of the face 4 to provide the small amount of buckling or folding of the peripheral portion 36 against the gasket edges when compressed by the biased contact member, to enhance electrical contact with the biased contact member 70. The small peripheral portion 36 of anode plate 21 that extends beyond the gasket 23, 28a surfaces (which buckles or folds) is preferably limited to less than the cumulative thicknesses of the anode gasket 23 and the cathode gasket 25 such that there is no risk that a buckled or folded anode plate 21 can extend sufficiently far out of the plane of the rest of the anode plate to reach the adjacent cathode plate 27 of the same cell. It may not matter if the peripheral portion 36 of the buckled anode plate 21 can reach the cathode plate 27 of the adjacent cell as shown in figure 6b, since this cathode plate is electrically coupled to the anode plate 21 anyway.

In a general aspect, the exposed edge 30 or the buckled / folded peripheral portion 36 of the flow plate comprise an exposed portion of the flow plate generally coplanar with the lateral face 4 of the fuel cell stack. The region of this exposed portion which is available for forming electrical contact with contacts of a connector assembly is referred to herein as a contact zone.

Figure 7 shows a schematic, partial perspective view of a corner part of a fuel cell stack 80 in a housing 81. One panel 82 of the housing 81 is shown partly detached to reveal the alignment of a set of flexing contacts 83 positioned for engagement with exposed portions 84 of the flow field plates 21. Some of the intervening layers have been omitted for clarity. Each of the flexing contacts 83 may make electrical contact with an edge of the respective flow plate 21 or may make electrical contact with a buckled or folded portion of the respective flow plate 21, as described in connection with figures 6a and 6b.

The flexing contacts 83 are, in this arrangement, mounted to the side panel 82 of the fuel cell stack housing. The side panel 82 may be formed from, or include thereon, a printed circuit board substrate with appropriate connecting tracks 85 for each of the flexing contacts 83. Integration of the flexing contacts 83 onto the housing 81 of a fuel cell stack, or onto panels of the housing, offers significant manufacturing advantages and automatic alignment of the contacts 83 with the respective flow plates 21.

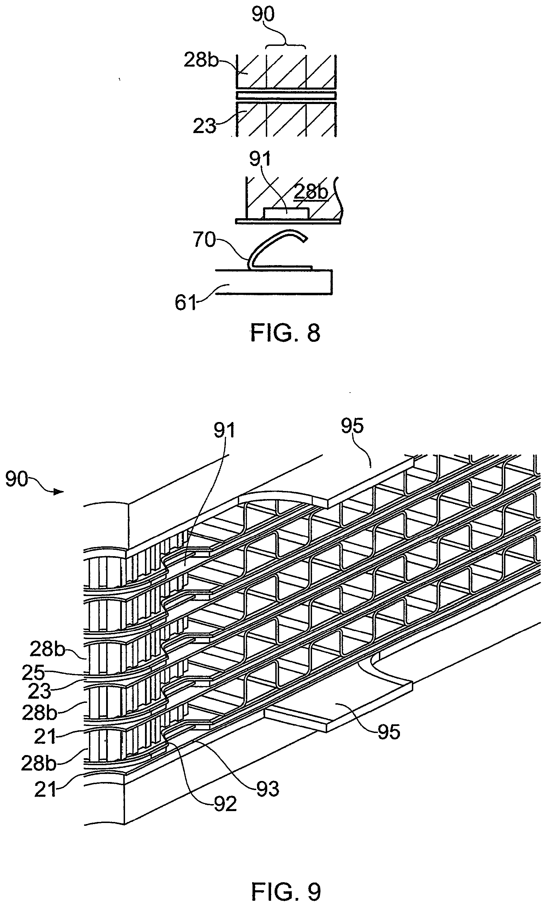

Figures 8 and 9 illustrate the arrangement according to the invention of contact zone for the flow plates 21 and respective contacts. In this example, the fuel cell stack 90 has a portion of the manifold gasket 28b (or 28a), the anode gasket 23 and the cathode gasket 25 cut back or rebated to form a recess 91 or rebate exposing a contact zone part 92 of the anode flow plate 21. The recess 91 ensures that an exposed edge 93 of the anode flow plate is available to be contacted by a biased contact 70, 45, 58, 66a, 66b of the various types previously described. The exposed edge 93 of the anode flow plate can be held in tension by any adjacent gaskets 23, 25 and/or 28b and therefore supported sufficiently to resist the biasing contact forces against its exposed edge 93 without buckling, folding or otherwise deforming. Alternatively, the buckling may be permitted for electrical contact as described in connection with the principles of figure 6b. The recesses 91 can be displaced along the face 4 of the stack so that they do not interfere with access to collector end plate tabs 95 which are used to extract power from the whole stack.

An advantage to providing recesses 91 for exposing a contact zone 92 is that the anode plate can be sized to be completely flush with the gasket edges, or even slightly recessive from the gasket edges, ensuring that no exposed edges of the flow plates appear outwith the gasket periphery.

Various modifications and adaptations are possible for all of the embodiments described. The contact zones / exposed portions and biased contacts 70 of the connector assembly could be spaced for contact with only selected cells, e.g. every other cell, or could be distributed in two or more rows across the face 4 of the stack similar to the arrangement shown in figure 1. The connector assembly can thus be configured with a contact spacing that is larger than the spacing between adjacent cells, the two rows being offset by one cell so as to facilitate a connection to every cell.

The contact zones can be provided for anode flow plates or cathode flow plates, or both. The contact zones can be applied on multiple edges of the flow plates. Contact zones could be provided on opposite edges of the flow plates, e.g. on opposite faces of the stack. Contact zones and their respective biased contacts could be provided on opposite faces of the stack to balance the inward forces generated by each set of biased contacts 70. This may have a number of design benefits such as avoiding any need for increased stack compression to compensate for laterally applied forces. For example, one set of biased contacts 70 on one face of the stack could be positioned to make contact with the odd numbered cells 2 in the stack and the other set of biased contacts 70 could be positioned to make contact with the even numbered cells 2 in the stack. As well as providing force balancing, this arrangement also provides for increased spacing between contacts. The connector assemblies can be adapted for any suitable connector pitch, e.g. 1 mm, 2 mm, 2.54 mm (0.1 inch), etc. A high degree of positional accuracy is possible with the various embodiments of connector assembly described.

The embodiments described above provide a modular design of stack assembly suitable for volume manufacture and provides a more compact connector assembly than tab-based designs. The embodiments described are particularly suitable for thin-gauge flow plate material, and for compact stacks with a small number of cells. The connector assemblies described can provide easier and more compact cable management than, for example, multiple connectors separately connecting to individual tabs.

Other embodiments are intentionally within the scope of the accompanying claims.

## Claims

1. A fuel cell stack assembly (1, 80, 90) comprising:
a plurality of fuel cells (20) disposed in a stacked configuration, each cell having a membrane-electrode assembly (MEA) (24) sandwiched between an anode flow field plate (21) and a cathode flow field plate (27),
the flow field plates (21, 27) each extending to a lateral face (4) of the fuel cell stack and each having an exposed portion (84) generally coplanar with the lateral face of the fuel cell stack surface;
a connector assembly (40, 50, 60) having an array of contacts (64, 70, 83) each configured to bias against, and form electrical contact with, a respective one of selected flow field plates (21, 27) at a contact zone (92) thereof, in which each contact is biased against its respective flow plate in a direction in the plane of the respective flow field plate; and
a gasket layer (23, 25, 28a, 28b) disposed on each side of each flow field plate (21, 27), the gasket layers supporting the faces of each flow field plate, at least one gasket layer adjacent each selected flow field plate including a rebate (91) at its peripheral edge to expose a portion (84) of the surface of the selected flow field plate inward of the lateral face (4) of the fuel cell stack at the contact zone (92).

2. The fuel cell stack assembly (1, 80, 90) of claim 1 in which the exposed portion (84) is an exposed edge (30, 93) of the respective flow field plate (21, 27) and each contact (64, 70, 83) is biased against the exposed edge of its respective flow plate.

3. The fuel cell stack assembly (1, 80, 90) of claim 2 in which the gasket layers (23, 25, 28a, 28b) support the faces of each flow field plate (21, 27) adjacent to the exposed edges (30, 93) that are in biased contact with a respective contact (64, 70, 83).

4. The fuel cell stack assembly (1, 80, 90) of claim 1 further comprising a recess (91) in the lateral face of the fuel cell stack at the contact zones (92).

5. The fuel cell stack assembly (1, 80, 90) of claim 1 in which the anode flow plate (21) of one cell comprises the cathode flow plate (27) of an adjacent cell, in a bipolar plate configuration.

6. The fuel cell assembly (1, 80, 90) of claim 1 in which the connector assembly (40, 50, 60) comprises a plurality of spring fingers (42) extending in a plane parallel or near parallel to the lateral face (4) of the stack, each spring finger (42) being biased towards the plane of the lateral face of the stack to engage with the exposed portion (84) of the respective one of the flow field plates (21, 27).

7. The fuel cell assembly (1, 80, 90) of claim 1 in which the connector assembly (40, 50, 60) comprises a resilient substrate defining a plurality of fingers (42) extending from a supporting spine in a comb-like configuration, the electrical contacts (45) being disposed on the spring fingers (42).

8. The fuel cell assembly (1, 80, 90) of claim 1 in which the connector assembly (40, 50, 60) comprises a plurality of spring loaded pins (54) each biased and extending towards the plane of the lateral face (4) of the stack to engage with the exposed portion (84) of the respective one of the flow field plates (21, 27).

9. The fuel cell assembly (1, 80, 90) of claim 1 in which the connector assembly (40, 50, 60) comprises a substrate on which is mounted a plurality of flexing contacts (64,83) extending away from the substrate to a knuckle contact portion (66, 66a, 66b).

10. The fuel cell assembly (1, 80, 90) of claim 1 in which the connector assembly (40, 50, 60) is integrated onto a side plate or housing (52, 62, 81) of the stack.

11. The fuel cell assembly (1, 80, 90) of claim 4 in which the recess (91) comprises a corner rebate in the stack at the contact zones (92).

12. The fuel cell stack assembly (1, 80, 90) of claim 1 in which the exposed portion (84) is a buckled or folded peripheral portion (36) of the respective flow field plate (21, 27) and each contact (64, 70, 83) is biased against the buckled or folded portion of its respective flow plate to thereby form the electrical contact (45) with the respective flow field plate.

13. The fuel cell stack assembly (1, 80, 90) of claim 1 further including a second connector assembly having an array of contacts (64, 70, 83) each configured to bias against, and form electrical contact with, a respective one of selected flow plates (21, 27) at a contact zone (92) thereof, in which each contact is biased against its respective flow plate in a direction in the plane of the respective flow plate, the second connector assembly being disposed on an opposite face of the fuel cell stack to the first connector assembly, to provide contact biasing in the opposite direction to the contacts of the first connector assembly.

## Patentansprüche

1. Brennstoffzellenstapelanordnung (1, 80, 90), Folgendes umfassend:
mehrere Brennstoffzellen (20), in einer Stapelkonfiguration angeordnet, wobei jede Zelle eine Membranelektrodenanordnung (MEA) (24) aufweist, die zwischen einer Anodenströmungsfeldplatte (21) und einer Kathodenströmungsfeldplatte (27) zusammengepresst ist,
wobei sich die Strömungsfeldplatten (21, 27) jeweils bis hin zu einer Seitenfläche (4) des Brennstoffzellenstapels erstrecken und jeweils einen freiliegenden Abschnitt (84) aufweisen, der im Allgemeinen koplanar mit der Seitenfläche der Brennstoffzellenstapeloberfläche ist;
eine Anschlussanordnung (40, 50, 60) mit einem Array von Kontakten (64, 70, 83), die jeweils konfiguriert sind, gegen eine entsprechende der ausgewählten Strömungsfeldplatten (21, 27) an einem Kontaktbereich (92) davon vorzuspannen und einen elektrischen Kontakt damit herzustellen, wobei jeder Kontakt gegen dessen jeweilige Strömungsplatte in einer Richtung in der Ebene der entsprechenden Strömungsfeldplatte vorgespannt wird; und
eine Dichtungsschicht (23, 25, 28a, 28b), angeordnet auf jeder Seite jeder Strömungsfeldplatte (21, 27), wobei die Dichtungsschichten die Flächen jeder Strömungsfeldplatte stützen, wenigstens eine Dichtungsschicht neben jeder ausgewählten Strömungsfeldplatte eine Aussparung (91) an ihrer Umlaufkante aufweist, um einen Abschnitt (84) der Oberfläche der ausgewählten Strömungsfeldplatte innerhalb der Seitenfläche (4) des Brennstoffzellenstapels an dem Kontaktbereich (92) freizulegen.

2. Brennstoffzellenstapelanordnung (1, 80, 90) nach Anspruch 1, wobei der freiliegende Abschnitt (84) eine freiliegende Kante (30, 93) der entsprechenden Strömungsfeldplatte (21, 27) ist und jeder Kontakt (64, 70, 83) gegen die freiliegende Kante von dessen entsprechender Strömungsfeldplatte vorgespannt ist.

3. Brennstoffzellenstapelanordnung (1, 80, 90) nach Anspruch 2, wobei die Dichtungsschichten (23, 25, 28a, 28b) die Flächen jeder Strömungsfeldplatte (21, 27) neben den freiliegenden Kanten (30, 93) stützen, die in vorgespannter Berührung mit einem entsprechenden Kontakt (64, 70, 83) stehen.

4. Brennstoffzellenstapelanordnung (1, 80, 90) nach Anspruch 1, ferner umfassend eine Einbuchtung (91) in der Seitenfläche des Brennstoffzellenstapels an den Kontaktbereichen (92).

5. Brennstoffzellenstapelanordnung (1, 80, 90) nach Anspruch 1, wobei die Anodenströmungsplatte (21) einer Zelle in einer bipolaren Plattenkonfiguration die Kathodenströmungsplatte (27) einer angrenzenden Zelle umfasst.

6. Brennstoffzellenanordnung (1, 80, 90) nach Anspruch 1, wobei die Anschlussanordnung (40, 50, 60) mehrere Federfinger (42) umfasst, die sich in einer Ebene parallel oder nahezu parallel zu der Seitenfläche (4) des Stapels erstrecken, wobei jeder Federfinger (42) zu der Ebene der Seitenfläche des Stapels hin vorgespannt ist, um mit dem freiliegenden Abschnitt (84) der jeweiligen der Strömungsfeldplatten (21, 27) in Eingriff zu treten.

7. Brennstoffzellenanordnung (1, 80, 90) nach Anspruch 1, wobei die Anschlussanordnung (40, 50, 60) ein elastisches Substrat umfasst, das mehrere Finger (42) definiert, die sich von einem Stützgrat aus kammfömig erstrecken, wobei die elektrischen Kontakte (45) an den Federfingern (42) angeordnet sind.

8. Brennstoffzellenanordnung (1, 80, 90) nach Anspruch 1, wobei die Anschlussanordnung (40, 50, 60) mehrere federbelastete Stifte (54) umfasst, die jeweils zu der Ebene der Seitenfläche (4) des Stapels hin vorgespannt sind und sich dorthin erstrecken, um mit dem freiliegenden Abschnitt (84) der jeweiligen der Strömungsfeldplatten (21, 27) in Eingriff zu treten.

9. Brennstoffzellenanordnung (1, 80, 90) nach Anspruch 1, wobei die Anschlussanordnung (40, 50, 60) ein Substrat umfasst, an dem mehrere biegsame Kontakte (64, 83) angebracht sind, die sich vom Substrat weg hin zu einem Gelenkkontaktabschnitt (66, 66a, 66b) erstrecken.

10. Brennstoffzellenanordnung (1, 80, 90) nach Anspruch 1, wobei die Anschlussanordnung (40, 50, 60) in eine Seitenplatte oder ein Gehäuse (52, 62, 81) des Stapels integriert ist.

11. Brennstoffzellenanordnung (1, 80, 90) nach Anspruch 4, wobei die Einbuchtung (91) eine Eckenaussparung in dem Stapel an den Kontaktbereichen (92) umfasst.

12. Brennstoffzellenstapelanordnung (1, 80, 90) nach Anspruch 1, wobei der freiliegende Abschnitt (84) ein geknickter oder gefalteter umlaufender Abschnitt (36) der jeweiligen Strömungsfeldplatte (21, 27) ist und jeder Kontakt (64, 70, 83) gegen den geknickten oder gefalteten Abschnitt von dessen Strömungsfeldplatte vorgespannt ist, um somit mit der entsprechenden Strömungsfeldplatte den elektrischen Kontakt (45) auszubilden.

13. Brennstoffzellenstapelanordnung (1, 80, 90) nach Anspruch 1, ferner enthaltend eine zweite Anschlussanordnung mit einem Array von Kontakten (64, 70, 83), die jeweils konfiguriert sind, gegen eine entsprechende der ausgewählten Strömungsfeldplatten (21, 27) an einem Kontaktbereich (92) davon vorzuspannen und einen elektrischen Kontakt damit herzustellen, wobei jeder Kontakt gegen dessen jeweilige Strömungsplatte in einer Richtung in der Ebene der entsprechenden Strömungsfeldplatte vorgespannt ist, wobei die zweite Anschlussanordnung auf einer der ersten Anschlussanordnung gegenüberliegenden Fläche des Brennstoffzellenstapels angeordnet ist, um eine Kontaktvorspannung in der den Kontakten der ersten Anschlussanordnung gegenüberliegenden Richtung bereitzustellen.

## Revendications

1. Ensemble empilement de piles à combustible (1, 80, 90) comprenant :
une pluralité de piles à combustible (20) disposées dans une configuration empilée, chaque pile ayant un ensemble membrane-électrode (MEA) (24) pris en sandwich entre une plaque de champ d'écoulement d'anode (21) et une plaque de champ d'écoulement de cathode (27),
les plaques de champ d'écoulement (21, 27) s'étendant chacune vers une face latérale (4) de l'empilement de piles à combustible et ayant chacune une partie exposée (84) généralement coplanaire avec la face latérale de la surface de l'empilement de piles à combustible ;
un ensemble connecteur (40, 50, 60) ayant un réseau de contacts (64, 70, 83) chacun configuré pour solliciter contre, et former un contact électrique avec, l'une respective de plaques de champ d'écoulement sélectionnées (21, 27) au niveau d'une zone de contact (92) de celles-ci, chaque contact étant sollicité contre sa plaque d'écoulement respective dans une direction dans le plan de la plaque de champ d'écoulement respective ; et
une couche de joint (23, 25, 28a, 28b) disposée sur chaque côté de chaque plaque de champ d'écoulement (21, 27), les couches de joint supportant les faces de chaque plaque de champ d'écoulement, au moins une couche de joint adjacente à chaque plaque de champ d'écoulement sélectionnée incluant une feuillure (91) au niveau de son bord périphérique pour exposer une partie (84) de la surface de la plaque de champ d'écoulement sélectionnée vers l'intérieur de la face latérale (4) de l'empilement de piles à combustible au niveau de la zone de contact (92).

2. Ensemble empilement de piles à combustible (1, 80, 90) selon la revendication 1, dans lequel la partie exposée (84) est un bord exposé (30, 93) de la plaque de champ d'écoulement (21, 27) respective et chaque contact (64, 70, 83) est sollicité contre le bord exposé de sa plaque d'écoulement respective.

3. Ensemble empilement de piles à combustible (1, 80, 90) selon la revendication 2, dans lequel les couches de joint (23, 25, 28a, 28b) supportent les faces de chaque plaque de champ d'écoulement (21, 27) adjacente aux bords exposés (30, 93) qui sont en contact sollicité avec un contact (64, 70, 83) respectif.

4. Ensemble empilement de piles à combustible (1, 80, 90) selon la revendication 1, comprenant en outre un évidement (91) dans la face latérale de l'empilement de piles à combustible au niveau des zones de contact (92).

5. Ensemble empilement de piles à combustible (1, 80, 90) selon la revendication 1, dans lequel la plaque d'écoulement d'anode (21) d'une pile comprend la plaque d'écoulement de cathode (27) d'une pile adjacente, dans une configuration de plaque bipolaire.

6. Ensemble de piles à combustible (1, 80, 90) selon la revendication 1, dans lequel l'ensemble connecteur (40, 50, 60) comprend une pluralité de doigts à ressort (42) s'étendant dans un plan parallèle ou presque parallèle à la face latérale (4) de l'empilement, chaque doigt à ressort (42) étant sollicité vers le plan de la face latérale de l'empilement pour s'enclencher avec la partie exposée (84) de l'une respective des plaques de champ d'écoulement (21, 27).

7. Ensemble de piles à combustible (1, 80, 90) selon la revendication 1, dans lequel l'ensemble connecteur (40, 50, 60) comprend un substrat résiliant définissant une pluralité de doigts (42) s'étendant depuis une épine de support dans une configuration semblable à un peigne, les contacts électriques (45) étant disposés sur les doigts à ressort (42).

8. Ensemble de piles à combustible (1, 80, 90) selon la revendication 1, dans lequel l'ensemble connecteur (40, 50, 60) comprend une pluralité de pieux chargés de ressort (54) chacun sollicité et s'étendant vers le plan de la face latérale (4) de l'empilement pour s'enclencher avec la partie exposée (84) de l'une respective des plaques de champ d'écoulement (21, 27).

9. Ensemble de piles à combustible (1, 80, 90) selon la revendication 1, dans lequel l'ensemble connecteur (40, 50, 60) comprend un substrat sur lequel est montée une pluralité de contacts de flexion (64, 83) s'étendant en éloignement du substrat vers une partie de contact de boucle (66, 66a, 66b).

10. Ensemble de piles à combustible (1, 80, 90) selon la revendication 1, dans lequel l'ensemble connecteur (40, 50, 60) est intégré sur une plaque latérale ou un logement latéral (52, 62, 81) de l'empilement.

11. Ensemble de piles à combustible (1, 80, 90) selon la revendication 4, dans lequel l'évidement **(91)** comprend une feuillure de coin dans l'empilement au niveau des zones de contact (92).

12. Ensemble empilement de piles à combustible (1, 80, 90) selon la revendication 1, dans lequel la partie exposée (84) est une partie périphérique bouclée ou pliée (36) de la plaque de champ d'écoulement (21, 27) respective et chaque contact (64, 70, 83) est sollicité contre la partie bouclée ou pliée de sa plaque d'écoulement respective pour former ainsi le contact électrique (45) avec la plaque de champ d'écoulement respective.

13. Ensemble empilement de piles à combustible (1, 80, 90) selon la revendication 1, incluant en outre un second ensemble connecteur comportant un réseau de contacts (64, 70, 83) chacun configuré pour solliciter contre, et former un contact électrique avec, l'une respective de plaques d'écoulement (21, 27) sélectionnées au niveau d'une zone de contact (92) de celles-ci, dans lequel chaque contact est sollicité contre sa plaque d'écoulement respective dans une direction dans le plan de la plaque d'écoulement respective, le second ensemble connecteur étant disposé sur une face opposée de l'empilement de piles à combustible au premier ensemble connecteur, pour créer une sollicitation par contact dans la direction opposée aux contacts du premier ensemble connecteur.
